Europäisches Patentamt

(19) European Patent Office

Office européen des brevets

(11) Publication number : **0 434 397 B1**

(12) **EUROPEAN PATENT SPECIFICATION**

(45) Date of publication of patent specification :
09.08.95 Bulletin 95/32

(51) Int. Cl.$^6$ : **H01L 39/02, H01B 12/02**

(21) Application number : 90313926.9

(22) Date of filing : 19.12.90

(54) **Oxide superconductive structure.**

(30) Priority : **19.12.89 JP 328930/89**

(43) Date of publication of application :
**26.06.91 Bulletin 91/26**

(45) Publication of the grant of the patent :
**09.08.95 Bulletin 95/32**

(84) Designated Contracting States :
**BE DE FR GB SE**

(56) References cited :
**PATENT ABSTRACTS OF JAPAN, vol. 013, no.
063 (C-568)() 13 February 1989 & JP-A-63 256
587
PATENT ABSTRACTS OF JAPAN, vol. 013, no.
109 (E-727)() 15 March 1989 & JP-A-63 279 521
PATENT ABSTRACTS OF JAPAN, vol. 13, no.
270 (E-776)() 21 June 1989 & JP-A-01 060 911**

(73) Proprietor : **NGK INSULATORS, LTD.
2-56, Suda-cho, Mizuho-ku
Nagoya City Aichi Pref. (JP)**

(72) Inventor : **Seike, Shoji
167-1, Taishi 2-chome,
Midori-ku
Nagoya-city, Aichi-Prefecture, 458 (JP)**
Inventor : **Okajima, Hisakazu, 59, Aza
Aotukayashiki
Ohaza Toyoba,
Toyoyama-cho
Nishikasugai-gun, Aichi-pref., 480-02 (JP)**
Inventor : **Shimizu, Hedeki, 205 NGK
Minami-shataku
15 Takeda-cho 2-chome,
Mizuho-ku
Nagoya-city, Aichi-prefecture (JP)**

(74) Representative : **Paget, Hugh Charles Edward
et al
MEWBURN ELLIS
York House
23 Kingsway
London WC2B 6HP (GB)**

## Description

The present invention relates to an oxide superconductive structure, and, more particularly, to an oxide superconductive structure capable of absorbing a thermal shock given thereto and preventing a deterioration in the characteristics even if it is immersed in liquid nitrogen so as to reveal superconductivity.

## Description of the Related Art

Recently, an oxide superconductive material (or structure) has attracted attention because of its significantly high critical temperature. Therefore, it has been expected that the oxide superconductive material is applied to an electric field, an MRI (Magnetic Resonance Imaging), a magnetic shield and the like.

The oxide superconductive material can be put into practical use in a manner in which the same is used as it is and in another manner in which a coating is applied to the surface thereof. As a superconductive material to which a coating is applied, a superconductor having the surface to which a water resistant resin or a metal film is applied has been disclosed in Japanese Patent Laid-Open No. 64-33087. Another superconductor having the surface to which a moisture resistant and airtight ceramics protection film is applied has been disclosed in Japanese Patent Laid-Open No. 63-256587.

However, conventional superconductors of the type to which no coating is applied encounter a problem of breakage due to the thermal shock when it is immersed in liquid nitrogen for the purpose of obtaining the superconductivity. Another problems arise in that microcracks are generated inside the superconductor due to the above-described thermal shock and the superconductivity is thereby critically deteriorated. Furthermore, the superconductor to which no coating is applied has a problem in that it is deteriorated by water in the atmosphere when it is left for a long time. Therefore, when it is taken out from the liquid nitrogen after the immersion, water in the atmosphere becomes bedewed on the surface of the superconductor, causing the characteristics to be critically deteriorated.

The superconductor disclosed in Japanese Patent Laid-Open No. 64-33087 suffers from the insufficient resistance against the thermal shock. Therefore, the superconductor will be broken when immersed into liquid nitrogen or microcracks can be generated inside the superconductor due to the thermal shock.

The superconductor disclosed in Japanese Patent Laid-Open No. 63-256587 arises a problem in that the overall resistance against a mechanical shock is insufficient since it is applied with a ceramic protection film.

## Summary of the Invention

Accordingly, an object of the present invention is to provide a superconductive structure capable of overcoming the above-described conventional problem and exhibiting satisfactory resistance against a thermal shock and mechanical shock.

According to the present invention, there is provided an oxide superconductive structure which comprises: an oxide superconductor of a multi-layered perovskite structure, and at least one covering layer which covers said oxide superconductor, at least one of said covering layer which has airtightness and non-water permeability, the relationship between the thermal conductivity and the average thickness of said covering layer meeting following equation (1),

$$\sum_i \frac{1}{\frac{(\text{Average thickness of covering layer } i)}{(\text{Thermal conductivity of covering layer } i \text{ at room temperature})}} < 0.5 \text{ cal/cm}^2 \text{ s K} \quad ...(1)$$

(where the unit of the average thickness is cm, the unit of the thermal conductivity is cal/cm secK),
and a covering layer positioned in contact with said oxide superconductor being not joined to said oxide superconductor.

The unit cal/cm sec °C is equivalent to $4.1868 \times 10^4$ W/m²K.

It is preferable that the covering layer be made of a material having no magnetism in order to sufficiently exhibit the magnetic shieldability caused by the superconducting properties.

Usually, the superconductor is an oxide having a multilayered perovskite structure composed of a Y-Ba-Cu-O compound or a Bi-Sr-Ca-Cu-O compound.

2

## Brief Description of the Drawings

Figs. 1A, 1B and 1C are schematic cross sectional views which illustrate a process of manufacturing an oxide superconductive structure according to the present invention;

Figs. 2 and 3 are schematic cross sectional views which respectively illustrate embodiments of the oxide superconductive structure according to the present invention; and

Figs. 4A and 4B are schematic cross sectional views which illustrate a process of manufacturing an oxide superconductive structure according to comparative example 4.

## Detailed Description of the Invention

The oxide superconductive structure according to the present invention comprises the oxide superconductor and at least one covering layer which covers the oxide superconductor. The covering layer has three characteristics (a) - (c) mentioned belows.

(a) the covering layer has airtightness and non-water permeability;

(b) the thermal conductivity and the average thickness of the layer meet the above-described specific relationship; and

(c) the layer which is positioned in contact with the superconductor is not joined to the superconductor (which means a fact that the surface of the superconductor and the covering layer can be independent from each other at the time of the thermal contraction).

As described above, the oxide superconductive structure according to the present invention is arranged in such a manner that the oxide superconductor is covered with a specific covering layer. Therefore, even if it is immersed in liquid nitrogen, a breakage due to the thermal shock can be prevented. Furthermore, when it has been taken out from the liquid nitrogen, the surface of the oxide superconductor is not bedewed with water in the atmosphere and the deterioration in the characteristics can thereby be prevented. Furthermore, resistance against the mechanical shock can be improved.

The covering layer according to the present invention is arranged to be composed of one or more materials, that is, one or more layers. Therefore, in the case where the covering layer is composed of one layer, the above-described characteristics (a), (b) and (c) of the covering layer according to the present invention must be satisfied by the one layer. In the case where the covering layer is composed of two or more layers, that is, a multi-layered structure, any of the following condition must be met:

(1) one of the layers meets conditions (a) and (b) and simultaneously the layer positioned in contact with the superconductor meets condition (c); or

(2) the covering layers which meet conditions (a) and (b) are respectively composed of one or more layers and the layer positioned in contact with the superconductor meets condition (c); or

(3) one of the layers meets condition (a), a multi-layered structure composed of two or more layers meets condition (b) and the layer positioned in contact with the superconductor meets condition (c).

The covering layer which covers the oxide superconductor must meet the following condition expressed by Equation (1):

$$\sum_i \frac{(\text{Average thickness of covering layer } i)}{(\text{Thermal conductivity of covering layer } i \text{ at room temperature})} < 0.5 \ldots (1)$$

(where, i denotes the number of the covering layers, the unit of the average thickness is cm, the unit of the thermal conductivity is cal/cm sec°C)

The above-described condition was found by the inventors of the present invention after various examinations and experiments, the condition being necessary to absorb the thermal shock and to prevent breakage or the like taken place when the oxide superconductor is immersed in liquid nitrogen.

That is, the inventors of the present invention have found a fact that the thermal shock of the superconductor can be absorbed by making the quantity of thermal conduction (heat flux) in the direction of the thickness of the covering layer per hour and unit cross sectional area (1 $cm^2$) to be smaller than 100. Namely, it is necessary to make the inverse number of the value obtained by dividing the average thickness of the covering layer by its thermal conductivity to be smaller than 0.5.

$$Q = A \frac{t_o - t_n}{\sum\limits_{i} \frac{d_i}{k_i}} \qquad \ldots (i)$$

$$0.5 > \frac{1}{\sum\limits_{i} \frac{d_i}{k_i}} \qquad \ldots (ii)$$

[where Q: heat flux (cal/sec), k: thermal conductivity (cal/cm sec°C), A: cross sectional area (cm$^2$), ($t_o$-$t_n$): temperature difference (°C), d: thickness (cm), i: the number of covering layers]

Assuming that Q is 100, the relationship between the material and the thickness becomes, for example, as follows:

| material | thickness |
|---|---|
| silicone rubber | 9 μm |
| aluminum | 1.1 cm |
| quartz glass | 74 μm |
| ceramic fiber | 43 μm |
| vinyl chloride | 7 μm |
| polyethylene | 10 μm |
| paper | 8 μm |
| air | 1 μm |

As the material to meet the above-described condition (b), an heat insulating material having flexibility is suitably employed. Therefore, a fiber material or a porous material made of metal, ceramics and/or organic compound is preferably used. Specifically, it is exemplified by, silicone rubber, urethane rubber, polyethylene, polypropylene, polyethylene foam sheet and inorganic fiber.

According to the present invention, it is necessary for the covering layer to meet the above-described condition (b) and for condition (c), that is, the condition that the layer positioned in contact with the superconductor is not joined to the superconductor to be met. As a result, the surface of the superconductor and the covering layer is able to be independent from each other against the thermal contraction. Therefore, even if the covering layer is contracted to a certain degree due to the thermal shock, the superconductor is not influenced. Thus, the breakage can be prevented and the superconductivity can be maintained.

As the material of the covering layer according to the present invention to meet condition (a): airtightness and non-water permeability is necessary, that is, a material which air and water cannot pass through is exemplified by a nylon/aluminum compound, a moisture resistant material such as a nylon multi-layered film, a silicone film, a polyfluoroethylene [trade name: Teflon (manufactured by Du pont)] such as polytetrafluoroethylene, and a metal container made of aluminum, copper and stainless steel.

In the case where a moisture resistant material is used as the outermost covering layer which covers the superconductor, thermal fixing may preferably be performed and a compound body is thereby formed so as to protect the entire surface of the superconductor from air and water. In the case where a metal container is used, the compound body is formed by employing O-rings and bolts for the same purpose. In this case, it is preferable that the inner portion of the airtight and non-water permeable covering material be made vacuum state or be filled with a dry gas.

It is preferable that the covering layer which covers the oxide superconductor be made of a material having no magnetism in the temperature range from room temperature to the temperature of the liquid nitrogen in order to sufficiently exhibit the magnetic shieldability caused by the superconducting properties. It is exemplified by silver, copper, aluminum, stainless steel (SUS304), inconnel, alumina, crystalized glass, nylon and silicone rubber.

As the oxide superconductor according to the present invention, it is preferable that a Y-Ba-Cu-O compound or a Bi-Sr-Ca-Cu-O compound of a multi-layered perovskite structure be employed. However, as an alternative to the sole superconductor, any structure may be employed if it has the superconductivity as the whole body, such structure being exemplified by a structure established by combining the superconductor and a substrate and a structure established by combining the superconductor and a multilayered substrate.

Preferred embodiments of the present invention will be described in detail. However, the present invention is not limited to the description about the embodiments.

(Example 1)

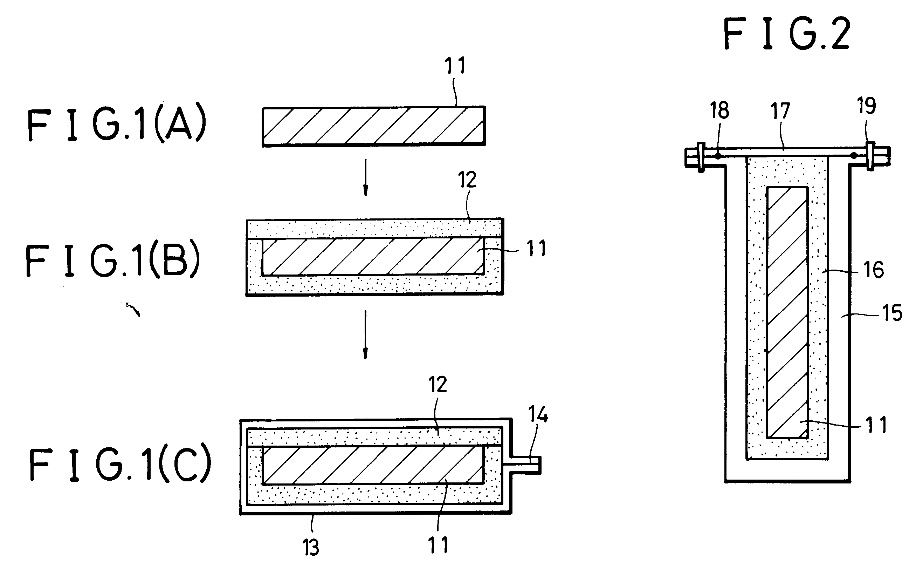

Fig. 1 is a schematic cross sectional view which illustrates a process of manufacturing an oxide superconductive structure according to the present invention.

First, as shown in Fig. 1A, an oxide superconductor 11 which was a sintered body of a perovskite structure composed of a Y-Ba-Cu-O compound the size of which is $300 \times 300 \times 5$ (mm) was prepared. Then, it was, as shown in Fig. 1B, covered with a silicone rubber 12 the thickness of which was 50 μm in such a manner that the interface was made to be free from the outer surface of the oxide superconductor 11. Then, as shown in Fig. 1C, the silicone rubber 12 was packed by an aluminum material 13 the thickness of which was 30 μm before a laminate portion 14 of the aluminum material 13 was fixed by heat so that an oxide superconductive structure was obtained.

The inverse number of the sum of the value obtained by dividing the average thickness of the silicone rubber layer by the thermal conductivity of the silicone rubber in room temperature, and the value obtained by dividing the average thickness of the aluminum layer by the thermal conductivity of aluminum in room temperature was measured, resulting to be 0.10, as shown below.

$$\frac{1}{\dfrac{\text{the average thickness of the silicone rubber layer}}{\text{the thermal conductivity of silicone rubber in room temperature} } + \dfrac{\text{the average thickness of the aluminium layer}}{\text{the thermal conductivity of aluminium in room temperature}}} = 0.10$$

The obtained oxide superconductive structure was subjected to experiments five times in each of which it is immersed in liquid nitrogen for 60 minutes before allowing to stand at room temperature for 60 minutes. As a result, no damage was found as shown in Table 1, and no deterioration in the superconductivity was observed. Furthermore, it was exposed to the atmosphere for 10 days so as to again evaluate the characteristics. As a result, no deterioration in the characteristics was observed.

(Example 2)

The oxide superconductor 11 the dimensions and the composition of which were the same as those according to Example 1 was vacuum-packed by a moisture resistant material made of an aluminum/nylon compound the thickness of which was 120 μm in such a manner that the interface with the outer surface of the oxide superconductor 11 was free from each other so that an oxide superconductive structure was obtained. The thus obtained oxide superconductive structure was subjected to the experiments which were the same as those according to Example 1. As shown in Table 1, the results were satisfactory.

(Example 3)

The oxide superconductor 11 the dimensions and the composition of which were the same as those according to Example 1 was covered with inorganic fiber the thickness of which was 500 μm before the inorganic fiber was packed by the aluminum material 13 the thickness of which was 30 μm. The laminate portion 14 of the aluminum material 13 was fixed by heat so that the oxide superconductive structure was obtained. The thus obtained oxide superconductive structure was subjected to the experiments which were the same as those according to Example 1. As shown in Table 1, the results were satisfactory.

(Example 4)

The oxide superconductor 11 the dimensions and the composition of which were the same as those according to Example 1 was accommodated in a stainless steel airtight container 15. Then, alumina powder 16 was filled in the width of 100 μm in a space around the oxide superconductor 11. The airtight container 15 was covered by a lid 17 before they were fixed by O-rings 18 and bolts 19 so that an oxide superconductive structure was obtained. The thus obtained oxide superconductive structure was subjected to the experiments which were the same as those according to Example 1. As shown in Table 1, the results were satisfactory.

(Example 5)

Coating was performed in the same manner as Example 4 except for the oxide superconductor 11 was covered with an alumina substrate the thickness of which was 300 μm. The thus obtained oxide superconductive structure was subjected to the experiments which were the same as those according to Example 1. As shown in Table 1, the results were satisfactory.

(Example 6)

The oxide superconductor 11 was accommodated in a stainless steel airtight container the thickness of which was 1 mm in such a manner that the interface was free from the surface of the oxide superconductor 11. Then, the oxide superconductive structure was manufactured in the same manner as Example 4. The thus obtained structure was subjected to the experiments which were the same as those according to Example 1. As shown in Table 1, the results were satisfactory.

(Example 7)

The oxide superconductor 11 was accommodated in an aluminum container the thickness of which was 12 mm in such a manner that the interface was free from the surface of the oxide superconductor 11. Then, the oxide superconductive structure was manufactured in the same manner as Example 4. The thus obtained structure was subjected to the experiments which were the same as those according to Example 1. As shown in Table 1, the results were satisfactory.

(Example 8)

The oxide superconductive structure was manufactured in the same manner as Example 1 except for the oxide superconductor the dimension of which was $300 \times 300 \times 0.3$ (mm), which was formed thick on a stainless steel substrate and which was made of Bi-Sr-Ca-Cu-O material. The thus obtained structure was subjected to the experiments which were the same as those according to Example 1. As shown in Table 1, the results were satisfactory.

(Example 9)

The oxide superconductive structure was manufactured in the same manner as Example 3 except for the oxide superconductor the dimension of which was $300 \times 300 \times 0.3$ (mm), which was formed thick on a stainless steel substrate and which was made of Bi-Sr-Ca-Cu-O material. The thus obtained structure was subjected to the experiments which were the same as those according to Example 1. As shown in Table 1, the results were satisfactory.

(Example 10)

The oxide superconductive structure was manufactured in the same manner as Example 3 except for the oxide superconductor which was a sintered cylinder the dimension of which was 100 $\phi \times$ 400 (length) $\times$ 5 (thickness) (mm) and except for the second layer of the covering layer was aluminum container 15 as shown in Fig. 2. The thus obtained structure was subjected to the experiments which were the same as those according to Example 1. As shown in Table 1, the results were satisfactory.

(Example 11)

The oxide superconductive structure was manufactured in the same manner as Example 10 except for the oxide superconductor which was composed of a Bi-Sr-Ca-Cu-O material and which was formed thick on a stainless steel cylinder. The thus obtained oxide superconductive structure was subjected to the experiments which were the same as those according to Example 1. As shown in Table 1, the results were satisfactory.

(Example 12)

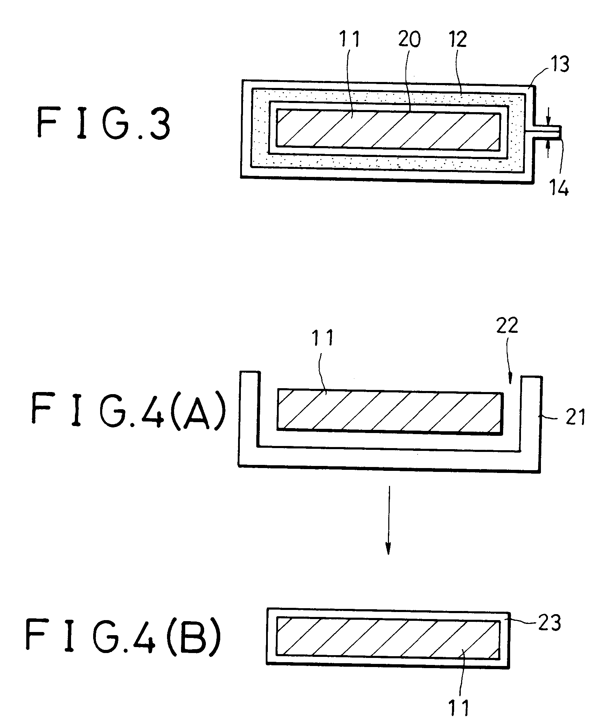

The oxide superconductor 11 the dimension and the composition of which were the same as those according to Example 1 was, as shown in Fig. 3, covered with aluminum foil 20 the thickness of which is 30 $\mu$m in such a manner that its interface with the outer surface of the oxide superconductor 11 is free from each other. Then, the silicone rubber 12 the thickness of which was 50 $\mu$m was applied on to the aluminum foil 20 before the aluminum material 13 the thickness of which was 30 mm was packed on to the silicone rubber 12. The aluminum material 13 was fixed by heat at the laminate portion 14 so that an oxide superconductive structure was obtained.

The thus obtained oxide superconductive structure was subjected to the experiments which were the same as those according to Example 1. As shown in Table 1, the results were satisfactory.

(Example 13)

An oxide superconductive structure was manufactured in the same manner as Example 12 except for the structure arranged in such a manner that the second layer of the covering layer employed a polyethylene foam sheet the thickness of which was 300 $\mu$m and the third layer was made of a moisture resistance material composed of an aluminum/nylon compound material. The thus obtained oxide superconductive structure was subjected to the experiments which were the same as those according to Example 1. As shown in Table 1, the results were satisfactory.

(Example 14)

The oxide superconductive structure was manufactured in the same manner as Example 12 except for the oxide superconductor the dimension of which was 300 $\times$ 300 $\times$ 0.3 (mm), which was formed thick on a stainless steel substrate and which was made of Bi-Sr-Ca-Cu-O material. The thus obtained structure was subjected to the experiments which were the same as those according to Example 1. As shown in Table 1, the results were satisfactory.

(Example 15)

The oxide superconductive structure was manufactured in the same manner as Example 13 except for the oxide superconductor the dimension of which was 300 $\times$ 300 $\times$ 0.3 (mm), which was formed thick on a stainless steel substrate and which was made of Bi-Sr-Ca-Cu-O material. The thus obtained structure was subjected to the experiments which were the same as those according to Example 1. As shown in Table 1, the results were satisfactory.

(Comparative Examples 1 and 2)

The oxide superconductors 11 were respectively accommodated in aluminum containers the thicknesses of which were 10 mm and 11 mm in such a manner that their interfaces were made free so that test samples were manufactured in the same manner as Example 7. The thus obtained test samples were subjected to the experiments which were the same as those according to Example 1. Its characteristics were, as shown in Table

7

2, deteriorated in the immersion test in liquid nitrogen.

(Comparative Example 3)

The oxide superconductors 11 was accommodated in a stainless steel airtight container the thicknesses of which was 800 μm in such a manner that its interface was made free so that a test sample was manufactured in the same manner as Example 6. The thus obtained test sample was subjected to the experiments which were the same as those according to Example 1. Its characteristics were, as shown in Table 2, deteriorated in the immersion test in liquid nitrogen.

(Comparative Example 4)

The oxide superconductor 11 same as that according to Example 1 was, as shown in Fig. 4A, accommodated in a polytetrafluoroethylene (Tradename:Teflon) container 21 while injecting a silicone rubber 22. A test sample formed by bonding a silicone rubber mold 23 the thickness of which was 200 μm on the interface of the oxide superconductor 11 was obtained as shown in Fig. 4B. The thus obtained test sample was subjected to the experiments which were the same as those according to Example 1. As a result, as shown in Table 2, the test sample was damaged in the immersion test into liquid nitrogen.

(Comparative Example 5)

A test sample was manufactured in the same manner as Comparative Example 4 except for the oxide superconductor the dimension of which was $300 \times 300 \times 0.3$ (mm), which was formed thick on a stainless steel substrate and which was made of Bi-Sr-Ca-Cu-O material. The thus obtained test sample was subjected to the experiments which were the same as those according to Example 1. As shown in Table 2, the test sample was damaged in the immersion test into liquid nitrogen.

(Comparative Example 6)

A test sample was manufactured in the same manner as Comparative Example 5 except for the oxide superconductor 11 was packed by an aluminum material having a thickness of 30μm. The thus obtained test sample was subjected to the experiments which were the same as those according to Example 1. As shown in Table 2, the test sample was damaged in the immersion test into liquid nitrogen.

(Comparative Examples 7 to 11)

As the oxide superconductor, a Y-Ba-Cu-O compound or Bi-Sr-Ca-Cu-O compound was used as shown in Table 2. The surface of the employed oxide superconductor was not applied with coating. As a result, as shown in Table 2, the test sample was damaged in the immersion test into liquid nitrogen or the characteristics were deteriorated. Furthermore, it was exposed to the atmosphere for 10 days so as to again evaluate the characteristics. As a result, deterioration in the characteristics were observed.

EP 0 434 397 B1

## Table 1

| No. | Superconductive material | | | Coating layer | Value of (1) | Evaluation | |
|---|---|---|---|---|---|---|---|
| | Materi-al | Dimension of Test sample (mm) | Remarks | First layer / Second layer / Third layer | | In Liquid N₂ | Allow to stand in air |
| Example 1 | YBCO | 300 ×300 ×5 | Sintered body | Silicone rubber (interface free) 50 μm/aluminum pack 30 μm | 0.10 | ○ | ○ |
| 〃 2 | YBCO | 300 ×300 ×5 | Sintered body | Moisture resistant vacuum Pack (interface Free) 120 μm | 0.18 | ○ | ○ |
| 〃 3 | YBCO | 300 ×300 ×5 | Sintered body | Inorganic fiber (interface free) 500 μm/aluminum pack | 0.04 | ○ | ○ |
| 〃 4 | YBCO | 300 ×300 ×5 | Sintered body | Aluminum powder (interface free) 100 μm/Stainless container | 0.19 | ○ | ○ |
| 〃 5 | YBCO | 300 ×300 ×5 | Sintered body | Aluminiau substrate (interface free) 300 μm/Stainless container | 0.35 | ○ | ○ |
| 〃 6 | YBCO | 300 ×300 ×5 | Sintered body | Stainless container 1mm (interface free) | 0.40 | ○ | ○ |
| 〃 7 | YBCO | 300 ×300 ×5 | Sintered body | Stainless container 12mm (interface free) | 0.48 | ○ | ○ |
| 〃 8 | BSCCO | 300 ×300 ×0.3 | Thick film on stain-less substrate | Silicone rubber (interface free)50 μm/Aluminum pack 30 μm | 0.10 | ○ | ○ |
| 〃 9 | BSCCO | 300 ×300 ×0.3 | Thick film on stain-less substrate | Inorganic fiber 500 μm/Aluminum pack 30 μm | 0.44 | ○ | ○ |
| 〃 10 | YBCO | 100 φ× 400ℓ ×5t | Cylindrical sintered body | Inorganic fiber 500 μm/Aluminum container | 0.04 | ○ | ○ |
| 〃 11 | BSCCO | 100 φ× 400ℓ ×0.3t | Thick film on stain-less cylinder | Inorganic fiber 500 μm/Aluminum container | 0.04 | ○ | ○ |
| 〃 12 | YBCO | 300 ×300 ×5 | Sintered body | Aluminum foil 30 μm/Silicone rubber50 μm/Aluminum pack 30 μm | 0.10 | ○ | ○ |
| 〃 13 | YBCO | 300 ×300 ×5 | Sintered body | Aluminum foil 30 μm /Polyethylene foam sheet 300 μm/ Moisture resistant vacuum pack | 0.02 | ○ | ○ |
| 〃 14 | BSCCO | 300 ×300 ×0.3 | Thick film on stain-less substrate | Aluminum foil 30 μm/Silicone rubber 50 μm/Aluminum pack 30 μm | 0.10 | ○ | ○ |
| 〃 15 | BSCCO | 300 ×300 ×0.3 | Thick film on stain-less substrate | Aluminum foil 30 μm /Polyethylene foam sheet 300 μm/ Moisture resistant vacuum pack | 0.02 | ○ | ○ |

Note) Evaluation: immersion in ligid nitrogen (five times) ○: No change, △ :characteristics deteriorated ×: broken
Exposure to air(10 days re-evaluation) ○: No change,×: characteristics deteriorated

EP 0 434 397 B1

## Table 2

| No. | Superconductive material | | | Coating layer | Value of equation (1) | Evaluation | |
|---|---|---|---|---|---|---|---|
| | Materi-al | Dimension of Test sample (mm) | Remarks | First layer / Second layer / Third layer | | In Liquid $N_2$ | Allow to stand in air |
| Comparative Example 1 | YBCO | 300 ×300 ×5 | Sintered body | Aluminum container 10mm (interface free) | 0.57 | △ | ○ |
| 〃 2 | YBCO | 300 ×300 ×5 | Sintered body | Aluminum container 11mm (interface free) | 0.52 | △ | ○ |
| 〃 3 | YBCO | 300 ×300 ×5 | Sintered body | Stainless container 800 μm (interface free) | 0.50 | △ | ○ |
| 〃 4 | YBCO | 300 ×300 ×5 | Sintered body | Silicon rubber mold (interface bonded) 200 μm | 0.02 | × | ○ |
| 〃 5 | BSCCO | 300 ×300 ×0.3 | Thick film on Stainless substrate | Silicon rubber mold (interface bonded) 200 μm | 0.02 | × | ○ |
| 〃 6 | BSCCO | 300 ×300 ×0.3 | Thick film on Stainless substrate | Aluminum pack 30 μm | 1.9 | × | ○ |
| 〃 7 | YBCO | 300 ×300 ×5 | Sintered body | No coating layer | — | × | × |
| 〃 8 | YBCO | 100 ×100 ×5 | Sintered body | | — | △ | × |
| 〃 9 | BSCCO | 300 ×300 ×0.3 | Thick film on Stainless substrate | | — | × | × |
| 〃 10 | BSCCO | 100 ×100 ×0.3 | Thick film on Stainless substrate | | — | △ | × |
| 〃 11 | BSCCO | 300 ×300 ×5 | Sintered body | | — | × | × |

(Note) immersion in liquid nitrogen (five times) ○ : No change, △ : characteristics deteriorated  × : broken.
Exposure to air  (10 days re-evaluation)  ○ : No change, × : characteristics deteriorated.

As described above, the oxide superconductive structure according to the present invention is covered with a covering layer which meets the specific conditions. Therefore, even if the superconductive structure is immersed in liquid nitrogen for the purpose of having its superconductivity to revealed, the thermal shock can be absorbed. Therefore, damage and deterioration in the characteristics due to the thermal shock can be prevented. Furthermore, resistance against the mechanical shock can be improved.

## Claims

1. An oxide superconductive structure which comprises:

an oxide superconductor,

and

at least one covering layer which covers said oxide superconductor, at least one of said covering layer or layers providing airtightness and non-water permeability, and the relationship between the thermal conductivity and the average thickness of said covering layer or layers satisfying the equation,

$$\frac{1}{\sum_i \frac{(\text{Average thickness of covering layer } i)}{(\text{Thermal conductivity of covering layer } i \text{ at room temperature})}} < 0.5 \text{ cal/cm}^2.s.K \ ...(1)$$

where the unit of the average thickness is cm, the unit of the thermal conductivity is cal/cm sec.K, and the covering layer positioned in contact with said oxide superconductor being not joined to said oxide superconductor.

2. An oxide superconductive structure according to Claim 1, wherein said covering layer is made of a material having no magnetism.

3. An oxide superconductive structure according to Claim 1 or 2, wherein said superconductor is an oxide having a multi-layered perovskite structure composed of a Y-Ba-Cu-O compound or a Bi-Sr-Ca-Cu-O compound.

4. An oxide superconductive structure according to Claim 1, wherein the covering layer is composed of one layer which has airtightness and non-water permeability and meets said equation, and the layer is not joined to the oxide superconductor.

5. An oxide superconductive structure according to Claim 1, wherein the covering layer is composed of at least two layers, one of the layers having airtightness and non-water permeability and meeting said equation, and the covering layer positioned in contact with the oxide superconductor is not joined to the superconductor.

6. An oxide superconductive structure according to Claim 1, wherein the covering layers having airtightness and non-water permeability and meeting said equation are respectively composed of at least one layer, and the covering layer positioned in contact with the oxide superconductor is not joined to the superconductor.

7. An oxide superconductive structure according to Claim 1, wherein the covering layer is composed of at least two layers, one of the layers having airtightness and non-water permeability, a multi-layered structure composed of at least two layers meets said equation, and the covering layer positioned in contact with the oxide superconductor is not joined to the superconductor.

## Patentansprüche

1. Oxidsupraleiter-Struktur, umfassend:

einen Oxidsupraleiter, und

zumindest eine Deckschicht, die den Oxidsupraleiter abdeckt, wobei die Deckschicht oder zumindest eine der Deckschichten für Luft- und Wasserundurchlässigkeit sorgt und der Zusammenhang zwischen der Wärmeleitfähigkeit und der mittleren Dicke der Deckschicht oder Deckschichten der folgenden Gleichung (1) genügt,

$$\sum_i \frac{1}{\dfrac{(\text{mittlere Dicke der Deckschicht } i)}{(\text{Wärmeleitfähigkeit der Deckschicht } i \text{ bei Raumtemperatur})}} < 0{,}5 \ \text{cal/cm}^2.\text{s.K} \quad (1)$$

wobei die Einheit der mittleren Dicke cm und die Einheit der Wärmeleitfähigkeit cal/cm.s.K ist, und wobei die Deckschicht, die mit dem Oxidsupraleiter in Kontakt steht, nicht mit dem Oxidsupraleiter verbunden ist.

2. Oxidsupraleiter-Struktur nach Anspruch 1, worin die Deckschicht aus einem Material ohne magnetische Eigenschaften besteht.

3. Oxidsupraleiter-Struktur nach Anspruch 1 oder 2, worin der Supraleiter ein Oxid mit einer mehrschichtigen Perovskit-Struktur aus einer Y-Ba-Cu-O- oder Bi-Sr-Ca-Cu-O-Verbindung ist.

4. Oxidsupraleiter-Struktur nach Anspruch 1, worin die Deckschicht aus einer luftdichten und wasserundurchlässigen Schicht besteht, die der Gleichung genügt und nicht mit dem Oxidsupraleiter verbunden ist.

5. Oxidsupraleiter-Struktur nach Anspruch 1, worin die Deckschicht aus zumindest zwei Schichten besteht, wobei eine der Schichten luftdicht und wasserundurchlässig ist und der Gleichung genügt und wobei die mit dem Oxidsupraleiter in Kontakt stehende Deckschicht nicht mit dem Supraleiter verbunden ist.

6. Oxidsupraleiter-Struktur nach Anspruch 1, worin die Deckschichten, die luftdicht und wasserundurchlässig sind und der Gleichung genügen, jeweils aus zumindest einer Schicht bestehen und wobei die mit dem Oxidsupraleiter in Kontakt stehende Deckschicht nicht mit dem Supraleiter verbunden ist.

7. Oxidsupraleiter-Struktur nach Anspruch 1, worin die Deckschicht aus zumindest zwei Schichten besteht, wobei eine der Schichten luftdicht und wasserundurchlässig ist, eine mehrschichtige Struktur aus zumindest zwei Schichten der Gleichung genügt und die mit dem Oxidsupraleiter in Kontakt stehende Deckschicht nicht mit dem Supraleiter verbunden ist.

**Revendications**

1. Structure d'oxyde supraconducteur qui comprend:
   - un oxyde supraconducteur, et
   - au moins une couche de revêtement qui recouvre ledit oxyde supraconducteur, au moins l'une de ladite ou desdites couche(s) de revêtement donnant une étanchéité à l'air et une imperméabilité à l'eau, et la relation entre la conductivité thermique et l'épaisseur moyenne de ladite ou desdites couche(s) de revêtement satisfaisant l'équation

1

$$\sum_i \frac{(\text{Epaisseur moyenne de la couche de revêtement } i)}{(\text{conductivité thermique de la couche de revêtement } i \text{ à température ambiante})} < 0,5 \text{ cal/cm}^2\text{sK} \quad (1)$$

où l'unité d'épaisseur moyenne est le centimètre, l'unité de conductivité thermique est le cal/cm s K, et

la couche de revêtement positionnée au contact dudit oxyde supraconducteur n'étant pas jointe audit oxyde supraconducteur.

2. Structure d'oxyde supraconducteur selon la revendication 1, dans laquelle ladite couche de revêtement est faite d'un matériau n'ayant pas de magnétisme.

3. Structure d'oxyde supraconducteur selon la revendication 1 ou 2, dans laquelle ledit supraconducteur est un oxyde ayant une structure multicouche de perovskite composée d'un composé Y-Ba-Cu-O ou d'un composé Bi-Sr-Ca-Cu-O.

4. Structure d'oxyde supraconducteur selon la revendication 1, dans laquelle la couche de revêtement est composée d'une couche qui présente une étanchéité à l'air et une imperméabilité à l'eau et remplit ladite l'air et une imperméabilité à l'eau et remplit ladite équation, et la couche n'est pas jointe à l'oxyde supraconducteur.

5. Structure d'oxyde supraconducteur selon la revendication 1, dans laquelle la couche de revêtement est composée d'au moins deux couches, l'une des couches présentant une étanchéité à l'air et une imperméabilité à l'eau et remplissant ladite équation, et la couche de revêtement positionnée au contact de l'oxyde supraconducteur n'est pas jointe au supraconducteur.

6. Structure d'oxyde supraconducteur selon la revendication 1, dans laquelle les couches de revêtement présentant une étanchéité à l'air et une imperméabilité à l'eau et remplissant ladite équation sont respectivement composées d'au moins une couche, et la couche de revêtement positionnée au contact de l'oxyde supraconducteur n'est pas jointe au supraconducteur.

7. Structure d'oxyde supraconducteur selon la revendication 1, dans laquelle la couche de revêtement est composée d'au moins deux couches, l'une des couches présentant une étanchéité à l'air et une imperméabilité à l'eau, une structure multicouche composée d'au moins deux couches remplit ladite équation, et la couche de revêtement positionnée au contact de l'oxyde supraconducteur n'est pas jointe au supraconducteur.

FIG.2

FIG.1(A)

FIG.1(B)

FIG.1(C)

FIG.3

11  20  12  13  14

FIG.4(A)

11  22  21

FIG.4(B)

23  11